# EUROPEAN PATENT APPLICATION

(11) **EP 4 277 050 A1**
(43) Date of publication of application: **15.11.2023**
(21) Application number: 22749140.4
(22) Date of filing: 29.01.2022
(51) Int. Cl.: H01S 5/062, H01S 5/026

(54) **LASER APPARATUS AND POWER ADJUSTMENT METHOD FOR OPTICAL NETWORK TERMINAL**

(30) Priority: 02.02.2021 CN 202110143338
(71) Applicant: Huawei Technologies Co., Ltd., Shenzhen, Guangdong 518129 (CN)
(72) Inventor: CHEN, Guangcan, Shenzhen, Guangdong 518129 (CN); CHENG, Yuanbing, Shenzhen, Guangdong 518129 (CN); CHANG, Tianhai, Shenzhen, Guangdong 518129 (CN)
(74) Representative: Gill Jennings & Every LLP
(86) International application number: PCT/CN2022/074877
(87) International publication number: WO 2022/166861

(57) **Abstract**

Embodiments of this application disclose a laser apparatus, applied to the field of optical communication. The apparatus includes: a laser device region, an electrical isolation region and a power adjustment region. When a laser bias voltage is applied in the laser device region, a first active layer generates a target optical signal, and the target optical signal is introduced into the power adjustment region that is optically coupled to the laser device region. The power adjustment region includes a second active layer. When a forward bias voltage is applied in the power adjustment region, the second active layer amplifies the target optical signal, and/or when a reverse bias voltage is applied in the power adjustment region, the second active layer attenuates the target optical signal. By amplifying or attenuating the target optical signal through the power tuning region, the apparatus disclosed in this application reduces a requirement of an optical line terminal OLT on a dynamic adjustment range of a burst-mode trans-impedance amplifier BM-TIA, thereby reducing device costs.

## Description

This application claims priority to Chinese Patent Application No. 202110143338.2, filed with the China National Intellectual Property Administration on February 2, 2021 and entitled "LASER APPARATUS AND POWER ADJUSTMENT METHOD FOR OPTICAL NETWORK TERMINAL", which is incorporated herein by reference in its entirety.

### TECHNICAL FIELD

This application relates to the field of optical communication, and in particular, to a laser apparatus and a power adjustment method for an optical network terminal.

### BACKGROUND

A passive optical network (Passive Optical Network, PON) is a single-fiber bidirectional optical access network. An optical line terminal (Optical Distribution Network, OLT) is connected to a plurality of optical network units (Optical Network Units, ONUs) by an optical distribution Network (Optical Distribution Network, ODN).

Due to uneven optical splitting of the ODN and different distances between the ONUs and the OLT, losses from the ONUs to the OLT are different. Consequently, when arriving at the OLT, burst optical signals sent by the ONUs have optical powers that are not equal. Therefore, the OLT needs to use a burst-mode trans-impedance amplifier (Burst-mode Trans-impedance Amplifier, BM-TIA) whose gain is adjustable and that can quickly switch a gain value to meet a requirement that output voltage signals of the BM-TIA have a consistent amplitude. Therefore, a broader dynamic adjustment range of the BM-TIA indicates that a larger loss difference can be balanced.

However, generally, the broader dynamic adjustment range of the BM-TIA indicates higher costs of the BM-TIA.

### SUMMARY

This application provides a laser apparatus and a power adjustment method for an optical network terminal, to adjust an optical transmit power of the laser apparatus through a power tuning region, thereby lowering a requirement of an OLT on a dynamic adjustment range of a BM-TIA, and reducing costs.

According to a first aspect, this application provides a laser apparatus. The apparatus includes: a laser device region, an electrical isolation region and a power adjustment region. The laser device region includes a first active layer, and when a laser bias voltage is applied in the laser device region, the first active layer generates a target optical signal. The target optical signal is introduced into the power adjustment region that is optically coupled to the laser device region. The electrical isolation region is arranged between the laser device region and the power adjustment region, and the electrical isolation region is configured to isolate electrical crosstalk between the laser device region and the power adjustment region. The power adjustment region includes a second active layer. When a forward bias voltage is applied in the power adjustment region, the second active layer gains the target optical signal, and/or when a reverse bias voltage is applied in the power adjustment region, the second active layer attenuates the target optical signal. Specifically, the power tuning region may gain the target optical signal through stimulated radiation, or attenuate the target optical signal through stimulated absorption. The target optical signal may be continuous laser light generated by a laser device, or may be signal light obtained through internal modulation.

In this application, the power tuning region of the laser apparatus may gain or attenuate the target optical signal, and therefore, broadens a power adjustment range of the laser apparatus. Therefore, by controlling the power tuning region to gain or attenuate the target optical signal, the requirement of the OLT on the dynamic adjustment range of the BM-TIA can be lowered, thereby reducing the costs.

In an optional manner of the first aspect, the electrical isolation region includes a third active layer. The third active layer is optically coupled to the first active layer and the second active layer

In an optional manner of the first aspect, the apparatus includes an integrated optical chip, and the integrated optical chip includes the laser device region, the electrical isolation region and the power adjustment region. One end of the power adjustment region coincides with one end of the electrical isolation region, and the other end of the electrical isolation region coincides with one end of the laser device region. The laser device region, the electrical isolation region, and the power adjustment region are integrated into an integrated optical chip, which can improve integration of the laser apparatus.

In an optional manner of the first aspect, the laser device region further includes a first substrate, a first lower limiting layer, and a first upper limiting layer. The power adjustment region further includes a second substrate, a second lower limiting layer, and a second upper limiting layer. The electrical isolation region further includes a third upper limiting layer, a third lower limiting layer, and a third substrate. The integrated optical chip meets any one or more of the following conditions: The first substrate, the second substrate, and the third substrate are made of a same material and belong to a same substrate layer; the first lower limiting layer, the second lower limiting layer, and the third lower limiting layer are made of a same material and belong to a same limiting layer; the first upper limiting layer, the second upper limiting layer, and the third upper limiting layer are made of a same material, and belong to a same limiting layer; and the first active region, the second active region, and the third active region are made of a same material, and belong to a same active layer. The first to the third lower limiting layers are collectively referred to as lower limiting layers. When the first lower limiting layer, the second lower limiting layer, and the third lower limiting layer in the integrated optical chip are made of a same material and belong to a same limiting layer, a process procedure of the lower limiting layer is simpler. For example, the first lower limiting layer, the second lower limiting layer, and the third lower limiting layer may be completed through a time of epitaxial growth. Therefore, this application can simplify a process procedure, thereby reducing the costs.

In an optional manner of the first aspect, the laser device region is a distributed feedback (Distributed Feedback Laser, DFB) laser device region or a distributed Bragg reflection (distributed Bragg reflector, DBR) laser device region. The laser device region further includes a grating, and the power adjustment region does not include a grating. When the laser device region generates the target optical signal through stimulated radiation, the grating in the laser device region is for wavelength selection. When the power adjustment region is for a gain, the second active region also generates stimulated radiation. However, if the power adjustment region includes a grating, a working state of the power adjustment region is affected.

In an optional manner of the first aspect, the laser device region further includes a first positive electrode and a first negative electrode, and the power adjustment region further includes a second positive electrode and a second negative electrode. The first positive electrode and the second positive electrode are isolated by the electrical isolation region, and the first negative electrode and the second negative electrode belong to a same negative electrode layer. This can simplify a process procedure of the electrode layer. For example, compared with forming an isolation region between the first negative electrode and the second negative electrode through etching, process complexity may be reduced.

In an optional manner of the first aspect, the power adjustment region further includes a second positive electrode and a second negative electrode, and the apparatus further includes a first single-pole double-throw switch. The second negative electrode is grounded, and the second positive electrode is connected to a common terminal of the first single-pole double-throw switch. A first terminal of the first single-pole double-throw switch is connected to a first positive voltage terminal, and a second terminal of the first single-pole double-throw switch is connected to a negative voltage terminal. When the first terminal is connected to the common terminal, the forward bias voltage is applied in the power adjustment region; and when the second terminal is connected to the common terminal, the reverse bias voltage is applied in the power adjustment region.

In an optional manner of the first aspect, the power adjustment region further includes a second positive electrode and a second negative electrode, and the apparatus further includes a first single-pole double-throw switch and a second single-pole double-throw switch. The second negative electrode is connected to a first common terminal of the first single-pole double-throw switch, and the second positive electrode is connected to a second common terminal of the second single-pole double-throw switch. A first terminal of the first single-pole double-throw switch is connected to a first positive voltage terminal, and a second terminal of the first single-pole double-throw switch is grounded. A third terminal of the second single-pole double-throw switch is connected to a second positive voltage terminal, and a fourth terminal of the second single-pole double-throw switch is grounded. When the first terminal is connected to the first common terminal, and the fourth terminal is connected to the second common terminal, the reverse bias voltage is applied in the power adjustment region. When the second terminal is connected to the first common terminal, and the third terminal is connected to the second common terminal, the forward bias voltage is applied in the power adjustment region.

In an optional manner of the first aspect, the first single-pole double-throw switch and/or the second single-pole double-throw switch further include/includes a control terminal, and the laser apparatus further includes a controller. The controller is connected to the control terminal. The controller is configured to control which terminal is connected to a common terminal of a single-pole double-throw switch.

In an optional manner of the first aspect, the laser apparatus further includes a driver, and the first positive voltage terminal is connected to the driver. The controller is connected to the driver. The controller is configured to control an output voltage of the driver, to enable a positive voltage terminal and/or a negative voltage terminal of the driver to provide voltages of different magnitudes.

According to a second aspect, this application provides a power adjustment method for an optical network terminal. The method includes: A first optical network terminal obtains a first adjustment value. The first optical network terminal includes a laser device region and a power adjustment region. The first optical network terminal applies a laser bias voltage in the laser device region to generate a target optical signal. The target optical signal is introduced into the power tuning region that is optically coupled to the laser device region. The first optical network terminal applies a forward bias voltage in the power tuning region to gain the target optical signal based on the first adjustment value. Alternatively, the first optical network terminal applies a reverse bias voltage in the power tuning region to attenuate the target optical signal based on the first adjustment value. Specifically, the power tuning region may gain the target optical signal through stimulated radiation, or attenuate the target optical signal through stimulated absorption. The target optical signal may be continuous laser light generated by a laser device, or may be signal light obtained through internal modulation.

In this application, the power tuning region of the first optical network terminal may gain or attenuate the target optical signal, and therefore, broadens a power adjustment range of the first optical network terminal. Therefore, by controlling the power tuning region to gain or attenuate the target optical signal, the requirement of the OLT on the dynamic adjustment range of the BM-TIA can be lowered, thereby reducing the costs.

In an optional manner of the second aspect, a gain range within which the target optical signal is gained by applying the forward bias voltage in the power tuning region is 0 to N decibels, and an attenuation range within which the target optical signal is attenuated by applying the reverse bias voltage in the power tuning region is 0 to -M decibels, where N and M are positive numbers.

In an optional manner of the second aspect, the first adjustment value is a first loss difference. The first loss difference is a difference between a second loss and a first loss. The first loss is a link loss between the first optical network terminal and an OLT. The second loss is a link loss between a second optical network terminal and the OLT. The first optical network terminal obtains a first optical received power of an optical signal from the OLT, and the first optical network terminal sends the first optical received power to the OLT. A difference between an optical transmitted power of the optical signal and the first optical received power is the first loss. Similarly, the OLT may obtain the second loss, and then obtain the first loss difference based on the first loss and the second loss.

In an optional manner of the second aspect, the first adjustment value is a first power difference. The first power difference is a difference between a first optical received power and a second optical received power. The first optical received power is an optical received power of a first optical signal received by an OLT from the first optical network terminal. The second optical received power is an optical received power of a second optical signal received by the OLT from a second optical network terminal.

In an optional manner of the second aspect, a power of the target optical signal is X decibel milliwatts dBm. The method further includes: The first optical network terminal applies the forward bias voltage in the power tuning region to gain the first optical signal. An optical transmitted power of the gained first optical signal is equal to X+N decibel milliwatts. X is a positive number. When the first optical network terminal sends the first optical signal by using a maximum gain, a maximum optical received power of the first optical signal can be ensured, thereby effectively reducing a probability that the first optical signal is not received by the OLT due to an excessively low power, and improving stability of receiving the optical signal.

In an optional manner of the second aspect, if the first adjustment value is less than or equal to N, a gain value by which the first optical network terminal gains the target optical signal through the power tuning region is N-Z decibels. Z is the first adjustment value. If the first adjustment value is greater than N and is less than or equal to N+M, an attenuation value by which the first optical network terminal attenuates the target optical signal through the power tuning region is Z-N decibels.

In an optional manner of the second aspect, the method further includes: If the first adjustment value is greater than N+M, the first optical network terminal reduces the laser bias voltage to reduce a power of the target optical signal. Reducing the laser bias voltage reduces the power of the target optical signal. Therefore, if an adjustment range of the power tuning region is insufficient, reducing the laser bias voltage may further broaden the power adjustment range of the first optical Network. Therefore, the requirement of the OLT on the dynamic adjustment range of the BM-TIA can be further lowered, and the costs can be reduced.

In an optional manner of the second aspect, a sum of N and M is greater than or equal to 15. A difference between optical transmit powers of different optical network terminals may reach 15 dB, that is, a power difference between different target optical signals may reach 15 dB. Therefore, if path losses between the different optical network terminals and the OLT are the same, a difference between optical received powers of the different optical network terminals arriving at the OLT can also reach 15 dB. Therefore, a sum of N and M is limited to be greater than or equal to 15.

In an optional manner of the second aspect, after the first optical network terminal gains or attenuates the target optical signal based on the first adjustment value, the method further includes: The first optical network terminal obtains a second adjustment value. If an absolute value of the second adjustment value is greater than a first threshold, the first optical network terminal adjusts, based on the second adjustment value, a gain value or an attenuation value by which the target optical signal is gained or attenuated based on the first adjustment value. After the first optical network terminal adjusts the power of the target optical signal based on the first adjustment value, if the optical transmit power of the first optical network terminal still fails to meet the requirement, the first optical network terminal may adjust, based on the second adjustment value, the gain value or the attenuation value by which the target optical signal is gained or attenuated based on the first adjustment value. Therefore, the optical transmitting power of the first optical network terminal may be further adjusted, that is, the optical received power of the OLT for the first optical network terminal is adjusted, thereby further ensuring that when arriving at the OLT, burst optical signals sent by the optical network terminals have optical powers that are equal. Therefore, the requirement of the OLT on the dynamic adjustment capability of the BM-TIA can be lowered, and the costs can be reduced.

In an optional manner of the second aspect, the laser bias voltage is a modulated electrical signal. When the laser bias voltage is the modulated electrical signal, the target optical signal is signal light obtained through internal modulation.

In an optional manner of the second aspect, a negative electrode of the power tuning region is grounded. A positive electrode of the power tuning region is connected to a common terminal of a single-pole double-throw switch. A first terminal of the single-pole double-throw switch is connected to a positive voltage terminal. A second terminal of the single-pole double-throw switch is connected to a negative voltage terminal. The first optical network terminal connects the first terminal and the common terminal to apply the forward bias voltage, to gain the target optical signal. The first optical network terminal connects the second terminal and the common terminal to apply the reverse bias voltage, to attenuate the target optical signal.

In an optional manner of the second aspect, a negative electrode of the power tuning region is connected to a first common terminal of a first single-pole double-throw switch. A positive electrode of the power tuning region is connected to a second common terminal of a second single-pole double-throw switch. A first terminal of the first single-pole double-throw switch is connected to a positive voltage terminal. A second terminal of the first single-pole double-throw switch is grounded. A third terminal of the second single-pole double-throw switch is connected to a negative voltage terminal. A fourth terminal of the first single-pole double-throw switch is grounded. The first optical network terminal connects the first terminal and the first common terminal, and the fourth terminal and the second common terminal, to apply the reverse bias voltage, to attenuate the target optical signal. The first optical network terminal connects the second terminal and the first common terminal, and the third terminal and the second common terminal, to apply the forward bias voltage, to gain the target optical signal.

In an optional manner of the second aspect, the laser device region is a DFB laser device region or a DBR laser device region.

According to a third aspect, this application provides a passive optical network (Passive Optical Network, PON) system. The system includes a first optical network terminal and an optical line terminal OLT. The first optical network terminal is configured to receive a first adjustment value sent by the OLT. The first optical network terminal is further configured to perform the method according to the second aspect or any one of the second aspect.

In an optional manner of the third aspect, the system further includes a second optical network terminal.

In an optional manner of the third aspect, the first adjustment value is the first loss difference. The OLT is configured to send an optical signal to the first optical network terminal and the second optical network terminal. The first optical network terminal is further configured to obtain a first optical received power of the optical signal, and send the first optical received power to the OLT. A difference between an optical transmitted power of the optical signal and the first optical received power is a first loss. The second optical network terminal is configured to obtain a second optical received power of the optical signal, and send the second optical received power to the OLT. A difference between the optical transmitted power of the optical signal and the second optical received power is a second loss. The OLT is configured to obtain a first loss difference based on the first loss and the second loss, and send the first loss difference to the first optical network terminal. The first loss difference is a difference between the second loss and the first loss.

In an optional manner of the third aspect, the first adjustment value is the first power difference. The first optical network terminal is further configured to send a first optical signal to the OLT. The second optical network terminal is configured to send a second optical signal to the OLT. The OLT is configured to obtain a first optical received power of the first optical signal and a second optical received power of the second optical signal, obtain a first power difference based on the first optical received power and the second optical received power, and send the first power difference to the first optical network terminal. The first power difference is a difference between the first optical received power and the second optical received power

In an optional manner of the third aspect, the system further includes an optical distribution network ODN. The ODN is configured to connect the first optical network terminal and the OLT.

A fourth aspect of this application provides a computer storage medium. The computer storage medium stores instructions. When the instructions are executed on a computer, the computer is enabled to perform the method according to the second aspect or any implementation of the second aspect.

A fifth aspect of this application provides a computer program product. When the computer program product is executed on a computer, the computer is enabled to perform the method according to the second aspect or any implementation of the second aspect.

### BRIEF DESCRIPTION OF DRAWINGS

FIG. 1 is a schematic diagram of a framework of a PON system in an application scenario of this application;
FIG. 2 is a schematic diagram of a structure of a laser apparatus according to this application;
FIG. 3 is a top view of a laser apparatus according to this application;
FIG. 4 is a schematic diagram of another structure of a laser apparatus according to this application;
FIG. 5 is a schematic diagram of another structure of a laser apparatus according to this application;
FIG. 6 is a schematic diagram of another structure of a laser apparatus according to this application;
FIG. 7 is a schematic flowchart of a power adjustment method for an optical network terminal according to this application;
FIG. 8 is a schematic flowchart of obtaining a first adjustment value according to this application;
FIG. 9 is another schematic flowchart of obtaining a first adjustment value according to this application;
FIG. 10 is a schematic diagram of a forward mapping relationship according to this application; and
FIG. 11 is a schematic diagram of a reverse mapping relationship according to this application.

### DESCRIPTION OF EMBODIMENTS

This application provides a laser apparatus and a power adjustment method for an optical network terminal. By controlling a power tuning region to gain or attenuate a target optical signal, a requirement of an OLT on a dynamic adjustment range of a BM-TIA can be lowered thereby reducing costs.

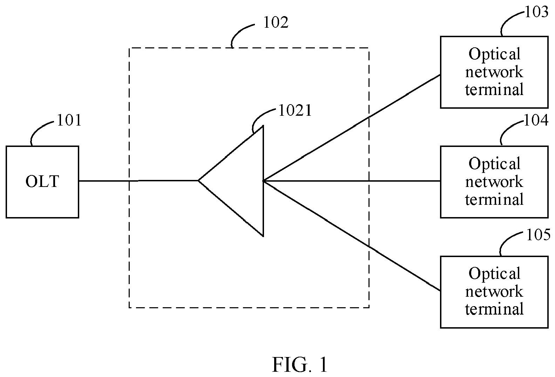

The laser apparatus and the power adjustment method for an optical network terminal in this application may be applied to the field of optical communication, for example, to a PON system. FIG. 1 is a schematic diagram of a framework of a PON system in an application scenario of this application. As shown in FIG. 1, the PON system includes an OLT 101, an ODN 102, and optical network terminals 103 to 105. The PON system is a point-to-multipoint single-fiber bidirectional optical access network (in FIG. 1, one OLT corresponds to three optical network terminals). Optical fibers and passive components (for example, an optical splitter/combiner 1021) are used in the ODN 102 in the PON system. In the PON system, the optical splitter/combiner 1021 is a point-to-multipoint core component, and the PON system uses the optical splitter/combiner 1021 to separate and collect optical signals transmitted through a network. Specifically, in a downlink direction, the OLT 101 distributes optical signals to all ONUs through the optical splitter/combiner 1021. In an uplink direction, optical signals from the ONUs are coupled to a same optical fiber through the optical splitter/combiner 1021 in a time division manner, and transmitted to the OLT 101. The optical network terminals 103 to 105 may be optical network units ONU or optical network terminals ONT.

Due to uneven optical splitting of the ODN and different distances between the optical network terminals and the OLT, losses from the optical network terminals to the OLT are different, and further, when arriving at the OLT, optical signals sent by the optical network terminals have optical received powers that are not equal. For the OLT side, a communication signal of each optical network terminal is a burst optical signal. A photoelectric detector of the OLT converts received burst optical signals with optical received powers that are not equal into electrical signals with different amplitudes. Then, the OLT amplifies the electrical signals with the different amplitudes into voltage signals with a same amplitude through a trans-impedance amplifier (Trans-impedance Amplifier, TIA). In this process, a BM-TIA whose gain is adjustable and that can quickly switch a gain value needs to be used, to meet a requirement that voltage signals output by the TIA have a consistent amplitude. Therefore, a broader dynamic adjustment range of the BM-TIA indicates that a larger loss difference can be balanced.

However, generally, the broader dynamic adjustment range of the BM-TIA indicates higher costs, and therefore, it is difficult to meet a low-cost requirement of the PON system.

Therefore, this application provides a laser apparatus. The laser apparatus may be an optical network terminal, an optical module in an optical network terminal, or an integrated optical chip in an optical module, and is configured to generate a modulated optical signal with an adjustable power. In essence, the foregoing method balances loss differences between different optical network terminals through the BM-TIA in the OLT. This application expects that the loss differences between different optical network terminals can be balanced at the optical network terminals. Therefore, an optical transmit power of the optical network terminal needs to be adjustable. Specifically, the laser apparatus includes a laser device region, a power adjustment region, and an electrical isolation region arranged between the laser device region and the power adjustment region. The laser device region is configured to generate a target optical signal. The power adjustment region includes a second active layer. When a forward bias voltage is applied in the power adjustment region, the power adjustment region gains (also referred to as amplifies) the target optical signal through the second active layer, and/or when a reverse bias voltage is applied in the power adjustment region, the power adjustment region attenuates the target optical signal through the second active layer

In the laser apparatus in this application, the power tuning region of the laser apparatus may gain or attenuate the target optical signal. Therefore, a power adjustment range of the laser apparatus is broadened, and a requirement of the OLT on a dynamic adjustment range of the BM-TIA is lowered. For example, an optical transmit power of a first optical network terminal and an optical transmit power of a second optical network terminal are both 8 dBm. A loss of an optical signal from the first optical network terminal arriving at the OLT is 15 dB, and a loss of an optical signal from the second optical network terminal arriving the OLT is 25 dB. In this case, an optical received power of an optical signal received by the OLT from the first optical network terminal is -7 dBm, and an optical received power of an optical signal received from the second optical network terminal is -17 dBm. To make a voltage gain range of the BM-TIA in the OLT equivalent to a power gain range of the optical signal, the BM-TIA needs at least a dynamic adjustment range of 10 dB (-17 dBm to -7 dBm). It is assumed that the laser apparatus in this application is used as the first optical network terminal, and an adjustment range of the power tuning region of the laser apparatus is 5 dB. If the laser apparatus adjusts the optical transmit power of the first optical network terminal to 2 dBm, the optical received power of the optical signal received by the OLT from the first optical network terminal is -12 dBm. The optical received power of the optical signal received by the OLT from the second optical network terminal remains unchanged. Therefore, the BM-TIA requires a dynamic adjustment range of 5 dB (-17 dBm to -12 dBm), which lowers the requirement of the OLT on the dynamic adjustment range of the BM-TIA. Therefore, costs of the BM-TIA in the OLT can be reduced. In addition, it takes time for the BM-TIA to adjust a gain. Therefore, a guard time is required between burst uplink signals of the different optical network terminals. The guard time is for adjusting the gain of the BM-TIA. Therefore, the OLT cannot receive, within the guard time, an uplink signal sent by an ONU, thereby reducing uplink bandwidth efficiency. Since in this application, the optical transmit power is adjusted on the optical network terminal side, the guard time can be reduced or even eliminated.

It should be understood that the foregoing example is merely for describing how to lower the requirement on the dynamic adjustment range of the BM-TIA (the requirement on the BM-TIA for short). In an actual application, a broader adjustment range of the laser apparatus indicates a lower requirement on the BM-TIA. Particularly, when optical transmit powers of different optical network terminals are equal, if the adjustment range of the laser apparatus is greater than the loss difference (for example, the foregoing 25 dB to 15 dB), the requirement on the BM-TIA may be reduced to 0 dB.

It should be understood that the application of the laser apparatus in the PON system is merely an example. In an actual application, if the optical transmit power of the optical network terminal needs to be adjusted, the laser apparatus provided in this application may be used.

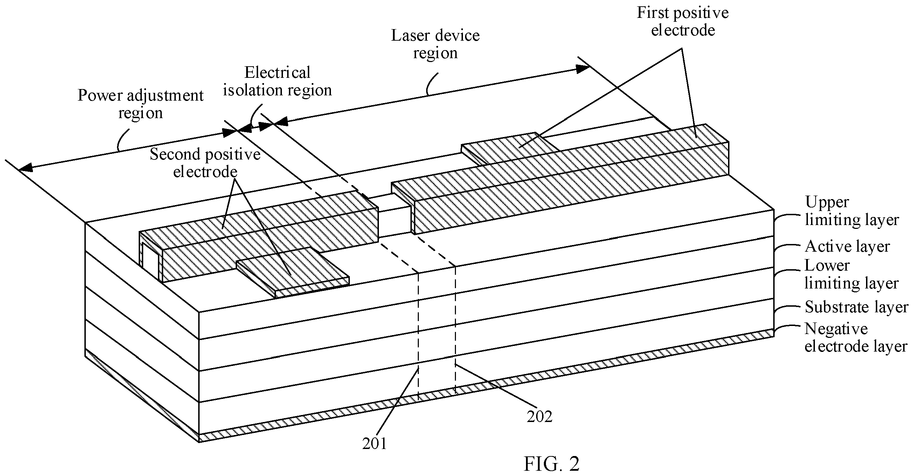

The following describes the laser apparatus in this application. FIG. 2 is a schematic diagram of a structure of a laser apparatus according to this application. As shown in FIG. 2, the laser apparatus may be an integrated optical chip, and the integrated optical chip includes a negative electrode layer, a substrate layer, a lower limiting layer, an active layer, and an upper limiting layer from bottom to top. A ridge waveguide and a positive electrode layer are further arranged above the upper limiting layer. The laser apparatus includes a laser device region, an electrical isolation region, and a power adjustment region (also referred to as a power tuning region) from right to left. One end of the laser device region coincides with one end of the electrical isolation region on a plane 202, and the other end of the electrical isolation region coincides with one end of the power adjustment region on a plane 201. The electrical isolation region does not include a positive electrode layer, and therefore, isolates a first positive electrode from a second positive electrode.

The plane 202 and the plane 201 divide the negative electrode layer into three parts, that is, a first negative electrode layer, a second negative electrode layer, and a third negative electrode layer. The first negative electrode layer is located at a right end of the plane 202, the second negative electrode layer is located at a left end of the plane 202, and the third negative electrode layer is located between the plane 202 and the plane 201. Similarly, the plane 202 and the plane 201 divide the substrate layer, the lower limiting layer, the active layer, and the upper limiting layer into three parts. Therefore, the laser device region includes the first negative electrode layer, a first substrate layer, a first lower limiting layer, a first active layer, and a first upper limiting layer. The power adjustment region includes the second negative electrode layer, a second substrate layer, a second lower limiting layer, a second active layer, and a second upper limiting layer. The electrical isolation region includes the third negative electrode layer, a third substrate layer, a third lower limiting layer, a third active layer, and a third upper limiting layer

The laser device region includes the first lower limiting layer, the first active layer, and the first upper limiting layer. By applying a laser bias voltage to the laser device region, carriers are injected into the active layer, and an inversion distribution of the carriers in the first active layer is established, that is, a population inversion occurs. In addition, to obtain stimulated radiation, the stimulated radiation need to be fed back a plurality of times in a resonant cavity to form laser oscillation, and a cavity surface or a grating can implement an optical feedback function to form the laser oscillation. In this embodiment of this application, a target optical signal is output from a left end face (the plane 202) of the laser device region.

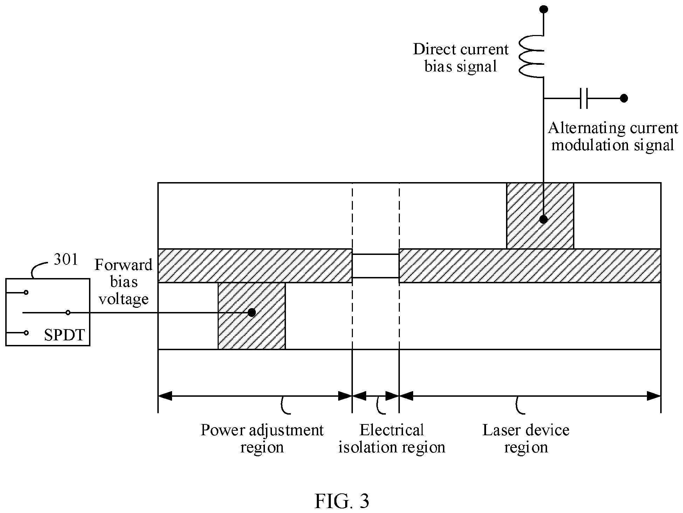

The target optical signal may be continuous laser light or signal light obtained through internal modulation. Generally, the laser bias voltage is applied to the first positive electrode, and the first negative electrode layer is grounded. By determining the laser bias voltage connected to the first positive electrode, whether the target optical signal is the continuous laser light or the modulated signal light may be determined. FIG. 3 is a top view of a laser apparatus according to this application. As shown in FIG. 3, a laser bias voltage applied to a first positive electrode may include a direct current bias signal and an alternating current modulation signal. When the laser bias voltage applied to the first positive electrode includes a direct current bias signal, but does not include an alternating current modulation signal, a target optical signal is continuous laser light. When the laser bias voltage applied by the first positive electrode includes both a direct current bias signal and an alternating current modulation signal, the target optical signal is modulated signal light.

It should be understood that a laser bias current is formed between the first positive electrode and a negative electrode layer by applying the laser bias voltage to the first positive electrode. Therefore, applying the laser bias voltage may also be understood as applying the laser bias current. Conversely, to apply the laser bias current, the laser bias voltage needs to be applied. Therefore, in descriptions of this application, the laser bias voltage is equivalent to the laser bias current. Similarly, in subsequent descriptions, a forward bias voltage is equivalent to a forward bias current, and a reverse bias voltage is equivalent to a reverse bias current.

An electrical isolation region includes a third active layer and a ridge waveguide. The third active layer introduces the target optical signal generated by a first active layer of a laser device region to a second active layer of a power adjustment region. The electrical isolation region does not include a positive electrode layer. In addition, when a contact layer is further included between the ridge waveguide and the positive electrode layer, the electrical isolation region does not include a contact layer. Specifically, a contact layer of the electrical isolation region may be etched after contact layers are uniformly epitaxially grown in the power adjustment region, the electrical isolation region, and the laser device region.

The power adjustment region includes a second positive electrode and a second negative electrode layer. The forward bias voltage may be applied to the power adjustment region through the second positive electrode and the second negative electrode layer. For example, as shown in FIG. 3, the second positive electrode is connected to a single-pole double-throw switch SPDT 301, and the second negative electrode is grounded. The forward bias voltage may enable the second active layer of the power adjustment region to gain the target optical signal through stimulated radiation. Specifically, when the forward bias voltage is applied to the power tuning region, electrons are injected to the second active layer to form a population inversion. When excited by the target optical signal, the second active region generates stimulated radiation, radiates an optical signal that has a same frequency and a same phase as the target optical signal, and forms a gain for the target optical signal. A magnitude of the gain may be adjusted based on a magnitude of the bias voltage. Therefore, the second active region may form a gain for the target optical signal, and a gain value may be adjusted based on a requirement. Conversely, the reverse bias voltage may also be applied to the power adjustment region through the second positive electrode and the second negative electrode layer. The reverse bias voltage may enable the second active layer of the power adjustment region to attenuate the target optical signal through stimulated absorption, and an attenuation value may also be adjusted based on a magnitude of the reverse bias voltage.

In another embodiment, an output end face (a left end face of the second active layer in FIG. 2) of the power adjustment region is plated with an anti-reflection film. The gained or attenuated target optical signal is output from the left end face of the second active layer, and an anti-reflection film is added to help reduce a reflection loss of the target optical signal.

As shown in FIG. 2, a process procedure of producing a laser device region includes: epitaxially growing a first lower limiting layer on a first substrate layer, epitaxially growing a first active layer on the first lower limiting layer, epitaxially growing a first upper limiting layer on the first active layer, epitaxially growing a p-type cover layer and a contact layer on the first upper limiting layer, making the P-type cover layer and the contact layer into a ridge waveguide, and finally adding a first negative electrode layer and a first positive electrode.

In another embodiment, the first substrate, a second substrate and a third substrate are made of a same material and belong to a same substrate layer. The first lower limiting layer, a second lower limiting layer, and a third lower limiting layer are made of a same material and belong to a same limiting layer. The first upper limiting layer, a second upper limiting layer, and a third upper limiting layer are made of a same material, and belong to a same limiting layer. The first active region, a second active region, and a third active region are made of a same material and belong to a same active layer. When the foregoing conditions are met, in a process procedure of manufacturing an integrated optical chip, a first lower limiting layer, a second lower limiting layer, a third lower limiting layer, a first active region, a second active region, a third active region, a first upper limiting layer, a second upper limiting layer, and a third upper limiting layer may be completed through a time of epitaxial growth. After fabrication of the grating is completed in the laser device region, growth of the P-type cover layer and the contact layer is completed through a second epitaxial growth. Therefore, in this embodiment of this application, manufacturing of the integrated optical chip can be completed through only two times of epitaxy, thereby reducing processing costs.

It should be understood that the integrated optical chip in FIG. 2 is merely an example. In an actual application, the integrated optical chip may have a more complex structure. For example, the integrated optical chip includes, from bottom to top, a negative electrode layer, an indium phosphate InP substrate, an InP buffer layer, a lower limiting layer, an active layer, an upper limiting layer, a P-type inner cover layer, an etching stop layer, a P-type cover layer, a P-type contact layer, a ridge waveguide, an insulation layer, and a positive electrode layer. A specific processing procedure is as follows: First, the InP buffer layer, the lower limiting layer, the active layer (the active layer may be of a multi-quantum well structure or a bulk material structure), and the upper limiting layer are epitaxially grown on the InP substrate in sequence. Then, the P-type inner cover layer, the etching stop layer, the P-type cover layer, and the P-type contact layer are epitaxially grown on the upper limiting layer. After epitaxial growth of the P-type contact layer is completed, the ridge waveguide is fabricated on the P-type contact layer. Then, the P-type contact layer of an electrical isolation region is etched to prevent current crosstalk between a laser device region and a power adjustment region. After fabrication of the electrical isolation region is completed, the insulation layer is grown on the ridge waveguide and the P-type contact layer, and a current injection window is opened on the ridge waveguide. Finally, the positive electrode layer is fabricated, and the negative electrode layer is fabricated on a thinned substrate.

In another embodiment, the laser device region is a DFB laser device region or a DBR laser device region, and the laser device region further includes a grating. The grating is for wavelength selection, and the grating may be located at the upper limiting layer or may be a separate grating layer. The power adjustment region does not include a grating.

It should be understood that the power adjustment region, the electrical isolation region, and the laser device region may be integrated on an integrated optical chip (for example, FIG. 2), or may be independent components. For example, in FIG. 2, the electrical isolation region does not include the ridge waveguide, the third upper limiting layer, the third active layer, the third lower limiting layer, the third substrate layer, and the third electrode layer. The electrical isolation region includes an optical coupling device 1, a waveguide, and an optical coupling device 2. The optical coupling device 1 is configured to introduce a target optical signal generated by the first active region into the waveguide, and the optical coupling device 2 is configured to introduce the target optical signal in the waveguide into the second active region. An anti-reflection film is plated on the left end face (the plane 202) of the laser device region. The power adjustment region and the laser device region may be made into independent devices, so that design is more flexible. For example, relative positions of the power adjustment region and the laser device region may be changed by changing a shape of the waveguide in the electrical isolation region.

It can be learned from the foregoing descriptions that the power adjustment region includes the second positive electrode and the second negative electrode layer. The following describes how to apply a bias voltage to the power adjustment region.

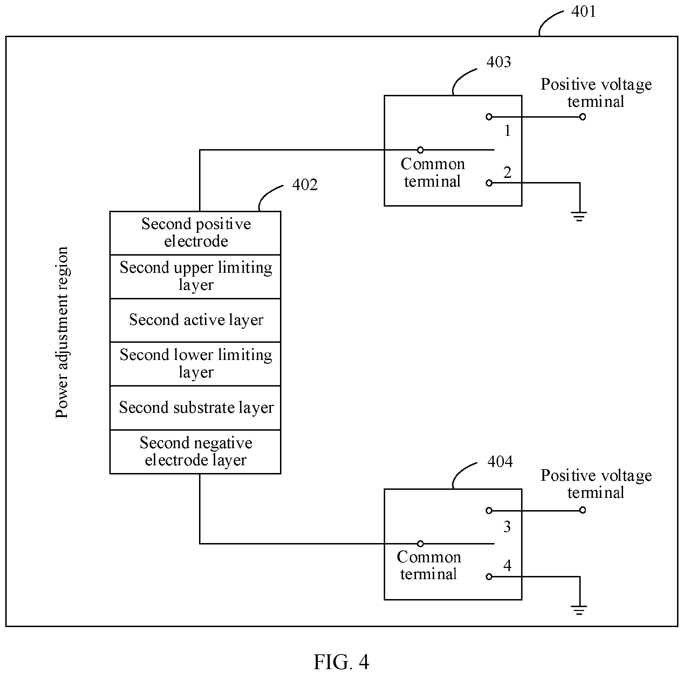

FIG. 4 is a schematic diagram of another structure of a laser apparatus according to this application. As shown in FIG. 4, a laser apparatus 401 includes a power adjustment region 402, a single-pole double-throw switch 404 (also referred to as a first single-pole double-throw switch), and a single-pole double-throw switch 403 (also referred to as a second single-pole double-throw switch). A second negative electrode layer (also referred to as a second negative electrode) of the power adjustment region 502 is connected to a common terminal of the single-pole double-throw switch 404, and a second positive electrode is connected to a common terminal of the single-pole double-throw switch 403. A port 3 (also referred to as a first terminal) of the single-pole double-throw switch 404 is connected to a first positive voltage terminal, and a port 4 (also referred to as a second terminal) of the single-pole double-throw switch 404 is grounded. A port 1 (also referred to as a third terminal) of the single-pole double-throw switch 403 is connected to a second positive voltage terminal, and a port 2 (also referred to as a fourth terminal) of the single-pole double-throw switch 403 is grounded. When the port 3 is connected to the first common terminal, and the port 2 is connected to the second common terminal, a reverse bias voltage is applied in the power adjustment region 402. When the port 4 is connected to the first common terminal, and the port 1 is connected to the second common terminal, a forward bias voltage is applied in the power adjustment region 402.

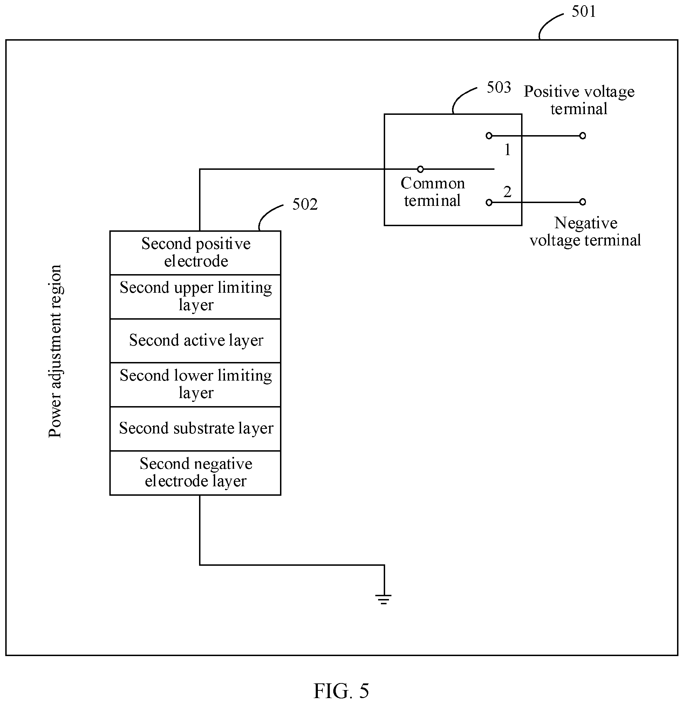

FIG. 5 is a schematic diagram of another structure of a laser apparatus according to this application. As shown in FIG. 5, a laser apparatus 501 includes a power adjustment region 502 and a single-pole double-throw switch 503 (also referred to as a first single-pole double-throw switch). A second negative electrode layer (also referred to as a second negative electrode) of the power adjustment region 502 is grounded. A second positive electrode of the power adjustment region 502 is connected to a common terminal of the single-pole double-throw switch 503. A port 1 (also referred to as a first terminal) of the single-pole double-throw switch 503 is connected to a positive voltage terminal, and a port 2 (also referred to as a second terminal) of the single-pole double-throw switch 503 is connected to a negative voltage terminal. When the port 1 is connected to the common terminal, a forward bias voltage is applied in the power adjustment region 502. When the port 2 is connected to the common terminal, a reverse bias voltage is applied in the power adjustment region 502.

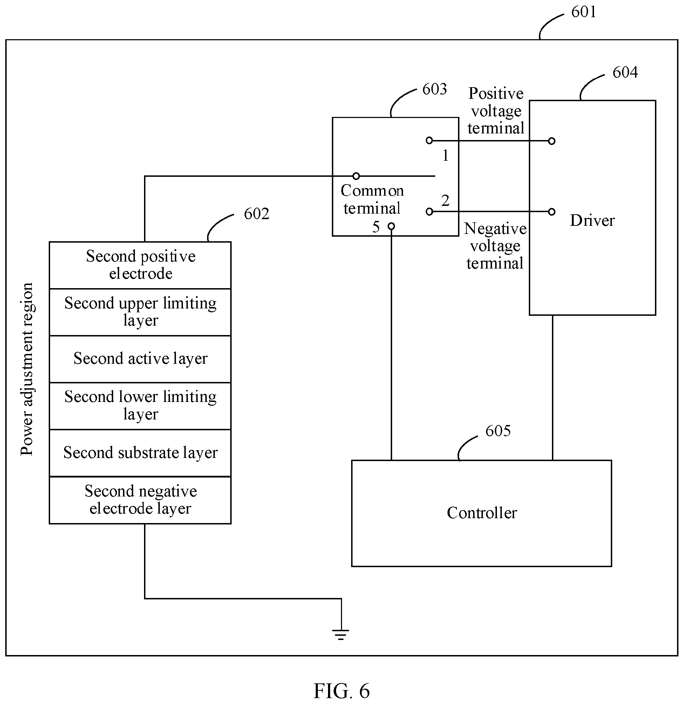

In addition to the single-pole double-throw switch, the laser apparatus may further include a controller and a driver. This is described below based on FIG. 5. FIG. 6 is a schematic diagram of another structure of a laser apparatus according to this application. As shown in FIG. 6, a laser apparatus 601 includes a power adjustment region 602, a single-pole double-throw switch 603, a controller 605, and a driver 604. A second negative electrode layer of the power adjustment region 602 is grounded. A second positive electrode of the power adjustment region 502 is connected to a common terminal of the single-pole double-throw switch 603. A port 1 of the single-pole double-throw switch 603 is connected to a positive voltage terminal of the driver 604, and a port 2 of the single-pole double-throw switch 603 is connected to a negative voltage terminal of the driver 604. A port 5 (also referred to as a control terminal) of the single-pole double-throw switch 603 is connected to the controller 605. The controller 605 is configured to control a common terminal of the single-pole double-throw switch 603 to connect to the port 1 or the port 2. The controller 605 is connected to the driver 604. The controller is configured to control an output voltage of the driver, to enable a positive voltage terminal and/or a negative voltage terminal of the driver to provide voltages of different magnitudes. Specifically, the controller may be a processor, for example, a medium access control (Media Access Control, MAC) chip.

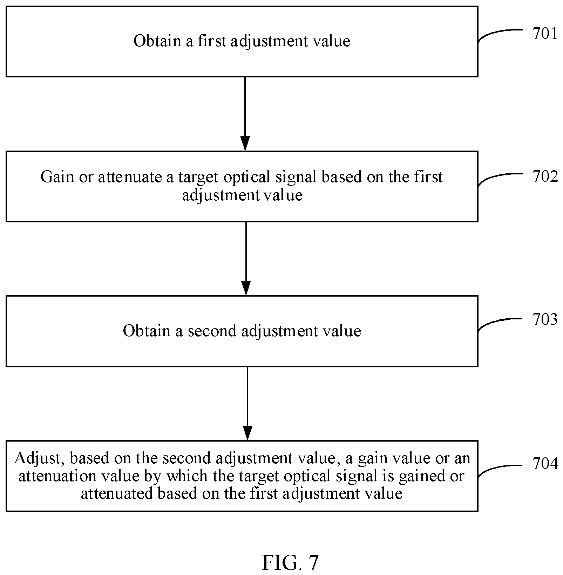

The laser apparatus is described above. The foregoing laser apparatus may be applied to an optical network terminal in a PON system. Specifically, an optical transmit power of the optical network terminal may be adjusted through the laser apparatus. The following describes the power adjustment method for an optical network terminal in this application. It can be learned based on the foregoing descriptions that the laser apparatus may be an optical network terminal, or an optical module in an optical network terminal, or an integrated optical chip in an optical module. The following describes technical solutions provided in this application by using an example in which the laser apparatus is an ONU. FIG. 7 is a schematic flowchart of a power adjustment method for an optical network terminal according to this application. As shown in FIG. 7, the method includes the following steps.

In step 701, a first ONU obtains a first adjustment value.

It can be learned from the foregoing descriptions of the laser apparatus that the laser apparatus may gain or attenuate a target optical signal, that is, a gain range and an attenuation range exist in a power adjustment region of the laser apparatus. An adjustment range of the first ONU includes the gain range and the attenuation range. The first adjustment value is for the first ONU to determine a gain value or an adjustment value. The first adjustment value may be a first power difference or a first loss difference. The following separately describes such two manners of obtaining the first adjustment value.

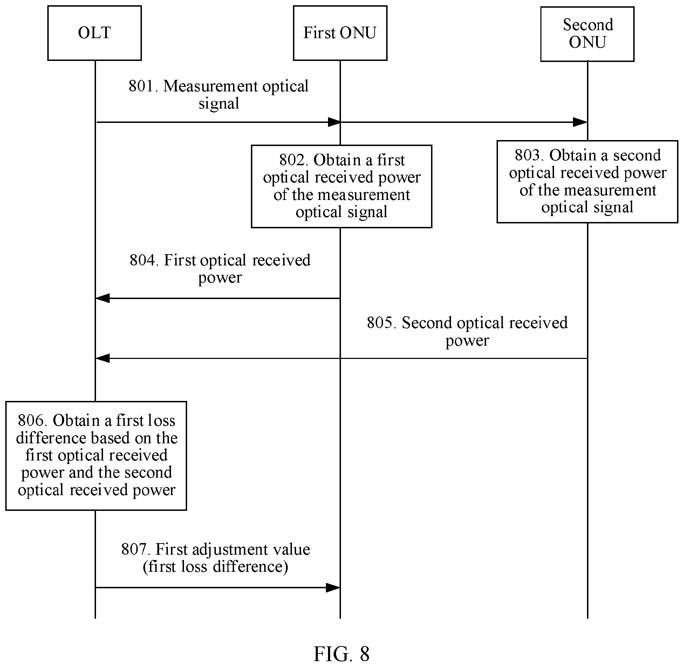

If the first adjustment value is the first loss difference, the first loss difference is a difference between a first loss and a target loss. The first loss is a link loss from the first ONU to an OLT. The target loss may be a loss value defined by the OLT, or may be a loss of another ONU connected to the OLT. For example, the target loss is a second loss, and the second loss is a link loss from a second ONU to the OLT. FIG. 8 is a schematic flowchart of obtaining a first adjustment value according to this application. As shown in FIG. 8, that a first ONU obtains a first adjustment value includes the following steps.

In step 801, an OLT sends a measurement optical signal to a first ONU and a second ONU.

It can be learned from the foregoing descriptions of a PON system that an optical splitter/combiner can split a measurement optical signal (an optical signal for short) to different ONUs, for example, the first ONU and the second ONU. When a MAC address carried in the measurement optical signal is a MAC address of the first ONU, the second ONU discards the measurement optical signal after receiving the measurement optical signal. However, the measurement optical signal is for measuring an optical received power of the second ONU, and discarding the measurement optical signal does not affect obtaining of a second optical received power by the second ONU. Therefore, content carried in the measurement optical signal is not limited in this application, for example, a MAC address, an IP address, or carried data. By sending a measurement optical signal once, the OLT may send the measurement optical signal to the first ONU and the second ONU at the same time. Alternatively, by sending a measurement optical signal twice, the OLT may separately send the measurement optical signal to the first ONU and the second ONU. The OLT records an optical transmitted power of the measurement optical signal.

In step 802, the first ONU obtains a first optical received power of the measurement optical signal.

In step 803, the second ONU obtains a second optical received power of the measurement optical signal.

In step 804, the first ONU sends the first optical received power to the OLT.

In step 805, the second ONU sends the second optical received power to the OLT.

In step 806, the OLT obtains a first loss difference based on the first optical received power and the second optical received power

In the foregoing step 801, the OLT records the optical transmitted power of the measured optical signal. A difference between the optical transmitted power and the first optical received power is a first loss, and a difference between the optical transmitted power and the second optical received power is a second loss. A difference between the second loss and the first loss is the first loss difference, and the second loss is greater than the first loss.

In another embodiment, the second loss is a maximum value of all losses. The all losses include link losses between all ONUs and the OLT, for example, the first loss and the second loss. When the OLT is connected to a plurality of ONUs, the OLT sends a measurement optical signal to the plurality of ONUs in step 801. After receiving a plurality of optical received powers sent by the plurality of ONUs, the OLT calculates a plurality of losses based on the plurality of optical received powers, and determines a loss with a largest value as a target loss, for example, the second loss. The plurality of ONUs are in a one-to-one correspondence with the plurality of losses. After determining the target loss, the OLT separately calculates differences between the remaining losses in the plurality of losses and the target loss, and sends the differences to corresponding ONUs, for example, sends the first loss difference to the first ONU. Particularly, because the second loss is the target loss, that is, the OLT uses the second loss as a reference, the second loss difference is 0. The OLT does not need to send the second loss difference to the second ONU.

In step 807, the OLT sends a first adjustment value to the first ONU. The first adjustment value is the first loss difference.

It should be understood that there is no strictly limited time sequence relationship among step 802 to step 805.

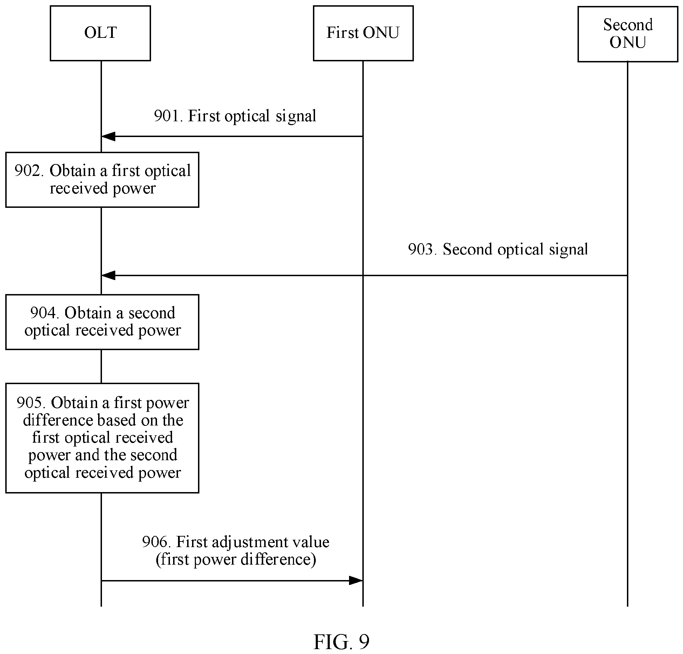

If the first adjustment value is the first power difference, the first power difference is a difference between the first optical received power and a target received power. The first optical received power is an optical received power of an optical signal received by the OLT from the first ONU. The target received power may be a received power defined by the OLT, or may be an optical received power of an optical signal received by the OLT from another ONU. For example, the optical received power is a second optical received power, and the second optical received power is an optical received power of an optical signal received by the OLT from the second ONU. FIG. 9 is another schematic flowchart of obtaining a first adjustment value according to this application. As shown in FIG. 9, another method for obtaining a first adjustment value by a first ONU includes the following steps.

In step 901, the first ONU sends a first optical signal to an OLT.

Because content carried in the first optical signal does not affect obtaining a first optical received power of the first optical signal by the first ONU, the content carried in the first optical signal is not limited in this application.

In step 902, the OLT obtains a first optical received power. The first optical received power is an optical received power of the first optical signal.

In step 903, a second ONU sends a second optical signal to the OLT.

It can be learned from the foregoing descriptions of the PON system that optical signals from ONUs are coupled to a same optical fiber through an optical splitter/combiner in a time division manner, and transmitted to the OLT. Therefore, to enable the OLT to accurately obtain the optical received power of the first optical signal, the first optical signal and the second optical signal are staggered in time domain, to avoid mutual interference.

In another embodiment, a power adjustment region in the first ONU maximally gains the first optical signal, and a power adjustment region in the second ONU maximally gains the second optical signal. For example, a gain range within which a target optical signal is gained by applying the forward bias voltage in the power tuning region is 0 to N decibels, and an attenuation range within which the target optical signal is attenuated by applying the reverse bias voltage in the power tuning region is 0 to - M decibels. If a power of the target optical signal generated by the laser device region is X dBm, an optical transmitted power of the first optical signal and an optical transmitted power of the second optical signal are equal to X+N dBm, where X is a positive number.

In step 904, the OLT obtains a second optical received power. The second optical received power is an optical received power of the second optical signal.

In step 905, the OLT obtains a first power difference based on the first optical received power and the second optical received power. The first power difference is a difference between the first optical received power and the second optical received power, and the first optical received power is greater than the second optical received power.

In another embodiment, the second optical received power is a minimum value of all optical received powers. The all optical received powers include link losses between all ONUs and the OLT, for example, the first optical received power and the second optical received power. When the OLT is connected to a plurality of ONUs, the OLT receives a plurality of optical signals sent by the plurality of ONUs. After receiving the plurality of optical signals sent by the plurality of ONUs, the OLT obtains a plurality of optical received powers of the plurality of optical signals, and determines an optical received power with a largest value in the plurality of optical received powers as a target optical received power, for example, the second optical received power. The plurality of ONUs are in a one-to-one correspondence with the plurality of optical received powers. After determining the target optical received power, the OLT separately calculates differences between the remaining optical received powers in the plurality of optical received powers and the target optical received power, and sends the differences to corresponding ONUs, for example, the first power difference is sent to the first ONU. Particularly, because the second optical received power is the target optical received power, that is, the OLT uses the second optical received power as a reference, a second power difference is 0. The OLT does not need to send the second power difference to the second ONU.

In step 906, the OLT sends a first adjustment value to the first ONU. The first adjustment value is the first power difference.

It should be understood that there is no strictly limited time sequence relationship among steps 901 to 904.

The first adjustment value is obtained in two manners as described above. In an actual application, one manner may be selected for obtaining the first adjustment value. The following describes content of performing power adjustment by the first ONU based on the first adjustment value.

In step 702, the first ONU gains or attenuates a target optical signal based on the first adjustment value.

The first ONU includes a laser device region and a power adjustment region. The first ONU applies a laser bias voltage in the laser device region to generate a target optical signal, and the target optical signal is introduced into the power tuning region that is optically coupled to the laser device region. The first ONU applies a forward bias voltage in the power tuning region to gain the target optical signal based on the first adjustment value. Alternatively, the first ONU applies a reverse bias voltage in the power tuning region to attenuate the target optical signal based on the first adjustment value. For descriptions of the laser device region and the power adjustment region, refer to the foregoing descriptions of the laser apparatus in FIG. 2 to FIG. 6. In addition, the foregoing description of the laser apparatus may be correspondingly applied to the power adjustment method for an optical network terminal. For example, an electrical isolation region is arranged between the laser device region and the power adjustment region in the first ONU, and a first active layer of the laser device region and a second active layer of the power adjustment region are made of a same material, and are located at a same active layer.

It can be learned from the foregoing descriptions of the first adjustment value that, regardless of whether the first adjustment value is the first loss difference or the first power difference, a unit of the first adjustment value is a power unit, for example, dB, dBm, or mW. However, in FIG. 2, the power adjustment region gains the target optical signal by applying a bias voltage. Therefore, the first adjustment value needs to be converted into a bias voltage. In addition, an initial state of the first ONU also affects conversion between the first adjustment value and the bias voltage. The initial state of the first ONU includes full-gain, no-adjustment, and full-attenuation. The full-gain means that the first ONU has maximally gained an optical signal. The no-adjustment means that the first ONU does not gain or attenuate an optical signal. The full-attenuation means that the first ONU has maximally attenuated an optical signal. For ease of description, a gain range within which the target optical signal is gained by applying the forward bias voltage in the power tuning region of the first ONU is limited to 0 to N decibels, and an attenuation range within which the target optical signal is attenuated by applying the reverse bias voltage in the power tuning region is limited to 0 to -M decibels. Z is the first adjustment value.

The following descriptions are provided using an example in which the first adjustment value is the first power difference. The first power difference is a difference between the first optical received power and the second optical received power

When the initial state of the first ONU is no-adjustment, if the first adjustment value is a positive value, indicating that the optical transmitted power of the optical signal needs to be reduced, the first ONU attenuates the target optical signal. Specifically, the first ONU converts the first adjustment value into a reverse bias voltage based on a reverse mapping relationship, and applies the reverse bias voltage in the power adjustment region, to attenuate the target optical signal generated by the laser device region. In this case, an attenuation value of the first ONU is Z decibels. If the first adjustment value is a negative value, indicating that the optical transmitted power of the optical signal needs to be increased, the first ONU gains the target optical signal. Specifically, the first ONU converts the first adjustment value into a forward bias voltage based on a forward mapping relationship, and applies the forward bias voltage in the power adjustment region, to gain the target optical signal generated by the laser device region. In this case, a gain value of the first ONU is Z decibels. If the first adjustment value is 0, indicating that the optical transmitted power of the optical signal does not need to be changed, the first ONU still maintains the no-adjustment state.

When the initial state of the first ONU is full-gain, if the first adjustment value is a positive value and is less than or equal to N, the first ONU needs to reduce a gain on the optical signal. Specifically, the first ONU obtains N-Z (N minus Z). The first ONU converts N-Z into a forward bias voltage based on a forward mapping relationship, and applies the forward bias voltage in the power adjustment region, to gain the target optical signal generated by the laser device region. In this case, a gain value of the first ONU is N-Z decibels. If the first adjustment value is greater than N and is less than or equal to N+M, the first ONU needs to change full-gain for the optical signal to attenuation for the optical signal. Specifically, the first ONU obtains Z-N. The first ONU converts Z-N into a reverse bias voltage based on a reverse mapping relationship, and applies the reverse bias voltage in the power adjustment region, to attenuate the target optical signal generated by the laser device region. In this case, an attenuation value of the first ONU is N-Z decibels. If the first adjustment value is equal to N, the first ONU needs to change full-gain for the optical signal to no-adjustment for the optical signal. In this case, a gain value or an attenuation value of the first ONU is 0 decibels. If the first adjustment value is a negative value, indicating that the optical transmitted power of the optical signal needs to be increased, the first ONU is already in a full-gain state, and therefore, the gain cannot be increased by increasing the forward bias voltage. Therefore, when the first ONU is in a full-gain state, in the embodiment in FIG. 9, it is meaningful to limit the first optical received power to be greater than the second optical received power, or limit the target optical received power to be a minimum value in a plurality of optical received powers. Conversely, if the second optical received power is greater than the first optical received power, the first adjustment value is a negative value. The first ONU cannot further increase the gain, that is, the OLT cannot balance the optical received powers of the OLT for the first ONU and the second ONU through the first ONU.

In another embodiment, if the first adjustment value is greater than N+M, the first ONU needs to continue to attenuate the optical signal based on changing full-gain of the optical signal to full-attenuation of the optical signal. It should be understood that the foregoing full-gain and full-attenuation are for an adjustment capability of the power adjustment region. In addition to the power adjustment region, the laser device region may also adjust a power of the target optical signal. Specifically, the target optical signal is attenuated by reducing the laser bias voltage.

When the initial state of the first ONU is full-attenuation, refer to the foregoing descriptions of that the initial state is full-gain.

The foregoing describes the three initial states of the first ONU. When the initial state of the first ONU is full-gain, the first ONU sends the first optical signal by using a maximum gain. If the power of the target optical signal generated by the laser device region is X decibel milliwatts, the optical transmitted power of the first optical signal is equal to X+N decibel milliwatts. Therefore, it can be ensured that the optical received power of the first optical signal is maximum, so that a probability that the first optical signal is not received by the OLT because the power is excessively low can be effectively reduced.

In step 703, the first ONU obtains a second adjustment value.

After the first ONU gains or attenuates the target optical signal, due to existence of an error, when arriving at the OLT, optical signals of a plurality of ONUs have optical received powers that are not necessarily equal. The error mainly comes from two aspects. One aspect is an error of a forward mapping relationship or a reverse mapping relationship. For example, when the first adjustment value is 5 dB, and the forward bias voltage applied in the power adjustment region is 3 V, a gain of 5 dB is provided. However, a forward bias voltage obtained based on the first adjustment value of 5 dB and the forward mapping relationship is 2.9 V, and a gain of the forward bias voltage of 2.9 V is 4.6 dB. Therefore, it may be understood as an error of a mapping relationship. The other aspect is a fluctuation error of a loss. That is, in a transmission process of an optical signal, the loss may change. Therefore, even after the first ONU gains or attenuates the target optical signal, when measurement is performed again, optical signals of the plurality of ONUs, when arriving at the OLT, have optical received powers that are not necessarily equal.

Therefore, after the first ONU gains or attenuates the target optical signal based on the first adjustment value, the first ONU obtains the second adjustment value. A manner in which the first ONU obtains the second adjustment value is similar to the foregoing manner in which the first ONU obtains the first adjustment value. For details, refer to the foregoing descriptions.

In another embodiment, the first adjustment value is a power difference, and the second adjustment value is a loss difference. That is, the first adjustment value is obtained in a manner corresponding to FIG. 9, and the second adjustment value is obtained in a manner corresponding to FIG. 8. In this case, the first adjustment value sent in step 906 may be carried in the measurement optical signal, to reduce interaction procedures between the ONUs and the OLT.

In step 704, the first ONU adjusts, based on the second adjustment value, a gain value or an attenuation value by which the target optical signal is gained or attenuated based on the first adjustment value.

When an absolute value of the second adjustment value is greater than a first threshold, the first ONU adjusts, based on the second adjustment value, a gain value or an attenuation value by which the target optical signal is gained or attenuated based on the first adjustment value. The following uses an example in which the initial state of the first ONU in step 702 is full-gain. If the first adjustment value is greater than N and is less than or equal to N+M, an attenuation value of the first ONU is N-Z decibels.

It is assumed that the second adjustment value is Y. If Y is a positive value and is less than N-Z, the first ONU needs to reduce a gain for the optical signal. The first ONU obtains N-Z-Y. The first ONU converts N-Z-Y into a forward bias voltage based on a forward mapping relationship, and applies the forward bias voltage in the power adjustment region, to gain the target optical signal generated by the laser device region. In this case, a gain value of the first ONU is N-Z-Y decibels. If Y is greater than N-Z and is less than N-Z+M, that the first ONU gains the optical signal changes to attenuating the optical signal. The first ONU obtains Y-(N-Z). The first ONU converts Y-(N-Z) into a reverse bias voltage based on a reverse mapping relationship, and applies the reverse bias voltage in the power adjustment region, to attenuate the target optical signal generated by the laser device region. In this case, an attenuation value of the first ONU is Y-(N-Z) decibels.

The foregoing describes the power adjustment method for an optical network terminal in this application. In the foregoing method, the forward mapping relationship and the reverse mapping relationship are mentioned. The following provides examples of the forward mapping relationship and the reverse mapping relationship.

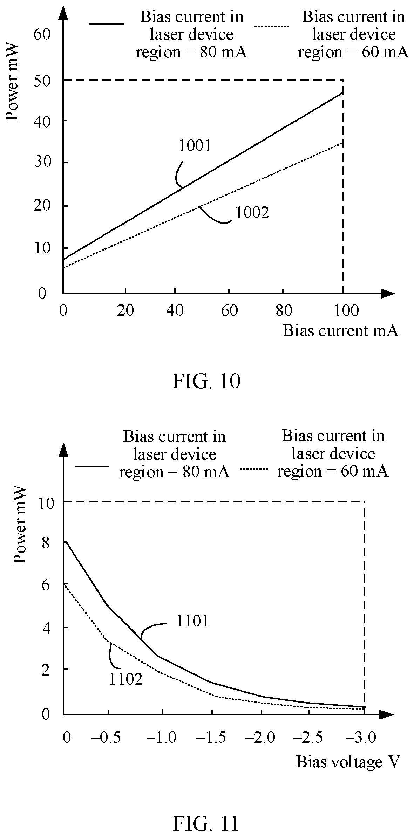

FIG. 10 is a schematic diagram of a forward mapping relationship according to this application. As shown in FIG. 10, a horizontal coordinate is a forward bias current, and a vertical coordinate is a power of a gained target optical signal. In FIG. 10, there are two forward mapping relationships. A bias current of a laser device region in a forward mapping relationship 1001 is 80 mA, and a bias current of the laser device region in a forward mapping relationship 1002 is 60 mA. The forward mapping relationship 1001 is used as an example. By increasing the forward bias current, a gain of a first ONU for the first ONU is also greater

FIG. 11 is a schematic diagram of a reverse mapping relationship according to this application. As shown in FIG. 11, a horizontal coordinate is a forward bias voltage, and a vertical coordinate is a power of a gained target optical signal. In FIG. 11, there are two reverse mapping relationships. A bias current of a laser device region in a reverse mapping relationship 1101 is 80 mA, and a bias current of the laser device region in a reverse mapping relationship 1102 is 60 mA. The reverse mapping relationship 1101 is used as an example. By increasing the forward bias current, a gain of a first ONU for the first ONU is also greater

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A laser apparatus, comprising: a laser device region, an electrical isolation region, and a power adjustment region, wherein the laser device region comprises a first active layer, and when a laser bias voltage is applied in the laser device region, the first active layer generates a target optical signal, wherein the target optical signal is introduced into the power adjustment region that is optically coupled to the laser device region;
the electrical isolation region is arranged between the laser device region and the power adjustment region;
the power adjustment region comprises a second active layer; and
when a forward bias voltage is applied in the power adjustment region, the second active layer gains the target optical signal, and/or when a reverse bias voltage is applied in the power adjustment region, the second active layer attenuates the target optical signal.

2. The apparatus according to claim 1, wherein the electrical isolation region comprises a third active layer, wherein
the third active layer is optically coupled to the first active layer and the second active layer.

3. The apparatus according to claim 1 or 2, wherein the apparatus comprises an integrated optical chip, and the integrated optical chip comprises the laser device region, the electrical isolation region, and the power adjustment region, wherein
one end of the power adjustment region coincides with one end of the electrical isolation region, and the other end of the electrical isolation region coincides with one end of the laser device region.

4. The apparatus according to claim 3, wherein the laser device region further comprises a first substrate, a first lower limiting layer, and a first upper limiting layer, the power adjustment region further comprises a second substrate, a second lower limiting layer, and a second upper limiting layer, and the electrical isolation region further comprises a third upper limiting layer, a third lower limiting layer, and a third substrate; and
the integrated optical chip meets any one or more of the following conditions:
the first substrate, the second substrate, and the third substrate are made of a same material and belong to a same substrate layer;
the first lower limiting layer, the second lower limiting layer, and the third lower limiting layer are made of a same material, and belong to a same limiting layer;
the first upper limiting layer, the second upper limiting layer, and the third upper limiting layer are made of a same material, and belong to a same limiting layer; and
the first active region, the second active region, and the third active region are made of a same material, and belong to a same active layer

5. The apparatus according to any one of claims 1 to 4, wherein the laser device region is a distributed feedback DFB laser device region or a distributed Bragg reflective DBR laser device region, and the laser device region further comprises a grating, wherein
the power adjustment region does not comprise a grating.

6. The apparatus according to any one of claims 1 to 5, wherein the laser device region further comprises a first positive electrode and a first negative electrode, and the power adjustment region further comprises a second positive electrode and a second negative electrode, wherein
the first positive electrode and the second positive electrode are isolated by the electrical isolation region, and the first negative electrode and the second negative electrode belong to a same electrode layer.

7. The apparatus according to claims 1 to 5, wherein the power adjustment region further comprises a second positive electrode and a second negative electrode, and the apparatus further comprises a first single-pole double-throw switch;
the second negative electrode is grounded, the second positive electrode is connected to a common terminal of the first single-pole double-throw switch, a first terminal of the first single-pole double-throw switch is connected to a first positive voltage terminal, and a second terminal of the first single-pole double-throw switch is connected to a negative voltage terminal;
when the first terminal is connected to the common terminal, the forward bias voltage is applied in the power adjustment region; and
when the second terminal is connected to the common terminal, the reverse bias voltage is applied in the power adjustment region.

8. The apparatus according to any one of claims 1 to 5, wherein the power adjustment region further comprises a second positive electrode and a second negative electrode, and the apparatus further comprises a first single-pole double-throw switch and a second single-pole double-throw switch, wherein
the second negative electrode is connected to a first common terminal of the first single-pole double-throw switch, the second positive electrode is connected to a second common terminal of the second single-pole double-throw switch, a first terminal of the first single-pole double-throw switch is connected to a first positive voltage terminal, a second terminal of the first single-pole double-throw switch is grounded, a third terminal of the second single-pole double-throw switch is connected to a second positive voltage terminal, and a fourth terminal of the second single-pole double-throw switch is grounded;
when the first terminal is connected to the first common terminal, and the fourth terminal is connected to the second common terminal, the reverse bias voltage is applied in the power adjustment region; and
when the second terminal is connected to the first common terminal, and the third terminal is connected to the second common terminal, the forward bias voltage is applied in the power adjustment region.

9. The apparatus according to claim 7 or 8, wherein the first single-pole double-throw switch and/or the second single-pole double-throw switch further comprise/comprises a control terminal, and the apparatus further comprises a controller, wherein
the controller is connected to the control terminal.

10. The apparatus according to claim 9, wherein the apparatus further comprises a driver, and the first positive voltage terminal is connected to the driver, wherein
the controller is connected to the driver.

11. A power adjustment method for an optical network terminal, comprising:
obtaining, by a first optical network terminal, a first adjustment value, wherein the first optical network terminal comprises a laser device region and a power adjustment region;
applying, by the first optical network terminal, a laser bias voltage in the laser device region to generate a target optical signal, wherein the target optical signal is introduced into the power tuning region that is optically coupled to the laser device region; and
applying, by the first optical network terminal, a forward bias voltage in the power tuning region to gain the target optical signal based on the first adjustment value; or
applying, by the first optical network terminal, a reverse bias voltage in the power tuning region to attenuate the target optical signal based on the first adjustment value.

12. The method according to claim 11, wherein a gain range within which the target optical signal is gained by applying the forward bias voltage in the power tuning region is 0 to N decibels, and an attenuation range within which the target optical signal is attenuated by applying the reverse bias voltage in the power tuning region is 0 to -M decibels, wherein N and M are positive numbers.

13. The method according to claim 12, wherein the first adjustment value is a first loss difference, the first loss difference is a difference between a second loss and a first loss, the first loss is a link loss between the first optical network terminal and an optical line terminal OLT, and the second loss is a link loss between a second optical network terminal and the OLT; and
the method further comprises:
obtaining, by the first optical network terminal, a first optical received power of an optical signal from the OLT; and
sending, by the first optical network terminal, the first optical received power to the OLT, wherein a difference between an optical transmitted power of the optical signal and the first optical received power is the first loss.

14. The method according to claim 12, wherein the first adjustment value is a first power difference, the first power difference is a difference between a first optical received power and a second optical received power, the first optical received power is an optical received power of a first optical signal received by an OLT from the first optical network terminal, and the second optical received power is an optical received power of a second optical signal received by the OLT from a second optical network terminal.

15. The method according to claim 14, wherein a power of the target optical signal is X decibel milliwatts, and the method further comprises:
applying, by the first optical network terminal, the forward bias voltage in the power tuning region to gain the first optical signal, wherein an optical transmitted power of the gained first optical signal is equal to X+N decibel milliwatts, wherein X is a positive number.

16. The method according to any one of claims 13 to 15, wherein the applying, by the first optical network terminal, the forward bias voltage in the power tuning region to gain the laser based on the first adjustment value comprises:
if the first adjustment value is less than or equal to N, a gain value by which the first optical network terminal gains the target optical signal through the power tuning region is N-Z decibels, wherein Z is the first adjustment value; and
the applying, by the first optical network terminal, a reverse bias voltage in the power tuning region to attenuate the laser based on the first adjustment value comprises:
if the first adjustment value is greater than N and is less than or equal to N+M, an attenuation value by which the first optical network terminal attenuates the target optical signal through the power tuning region is Z-N decibels.

17. The method according to claim 16, wherein the method further comprises:
reducing, by the first optical network terminal, the laser bias voltage if the first adjustment value is greater than N+M, to reduce a power of the target optical signal.

18. The method according to any one of claims 12 to 17, wherein a sum of N and M is greater than or equal to 15.

19. The method according to any one of claims 12 to 18, wherein after the first optical network terminal gains or attenuates the target optical signal based on the first adjustment value, the method further comprises:
obtaining, by the first optical network terminal, a second adjustment value; and
adjusting, based on the second adjustment value by the first optical network terminal if an absolute value of the second adjustment value is greater than a first threshold, a gain value or an attenuation value by which the target optical signal is gained or attenuated based on the first adjustment value.

20. The method according to any one of claims 12 to 19, wherein the laser bias voltage is a modulated electrical signal.

21. The method according to any one of claims 11 to 20, wherein a negative electrode of the power tuning region is grounded, a positive electrode of the power tuning region is connected to a common terminal of a single-pole double-throw switch, a first terminal of the single-pole double-throw switch is connected to a positive voltage terminal, and a second terminal of the single-pole double-throw switch is connected to a negative voltage terminal;
the applying, by the first optical network terminal, a forward bias voltage in the power tuning region to gain the target optical signal comprises:
connecting, by the first optical network terminal, the first terminal and the common terminal to apply the forward bias voltage, to gain the target optical signal; and
the applying, by the first optical network terminal, a reverse bias voltage in the power tuning region to attenuate the target optical signal comprises:
connecting, by the first optical network terminal, the second terminal and the common terminal to apply the reverse bias voltage, to attenuate the target optical signal.

22. The method according to any one of claims 11 to 20, wherein a negative electrode of the power tuning region is connected to a first common terminal of a first single-pole double-throw switch, a positive electrode of the power tuning region is connected to a second common terminal of a second single-pole double-throw switch, a first terminal of the first single-pole double-throw switch is connected to a first positive voltage terminal, a second terminal of the first single-pole double-throw switch is grounded, a third terminal of the second single-pole double-throw switch is connected to a second positive voltage terminal, and a fourth terminal of the first single-pole double-throw switch is grounded;
the applying, by the first optical network terminal, a forward bias voltage in the power tuning region to gain the target optical signal comprises:
connecting, by the first optical network terminal, the second terminal and the first common terminal, and the third terminal and the second common terminal, to apply the forward bias voltage, to gain the target optical signal; and
the applying, by the first optical network terminal, a reverse bias voltage in the power tuning region to attenuate the target optical signal comprises:
connecting, by the first optical network terminal, the first terminal and the first common terminal, and the fourth terminal and the second common terminal, to apply the reverse bias voltage, to attenuate the target optical signal.

23. The method according to any one of claims 11 to 22, wherein the laser device region is a distributed feedback DFB laser device region or a distributed Bragg reflective DBR laser device region.
